# EUROPEAN PATENT APPLICATION

(11) **EP 4 502 926 A1**
(43) Date of publication of application: **05.02.2025**
(21) Application number: 23188908.0
(22) Date of filing: 01.08.2023
(51) Int. Cl.: G06T 7/00, G06T 7/194, G01N 23/2251, G03F 7/00, G06V 20/69, H01L 21/66

(54) **DATA PROCESSING METHOD, CHARGED PARTICLE ASSESSMENT METHOD AND SYSTEM**

(71) Applicant: ASML Netherlands B.V., 5500 AH Veldhoven (NL)
(72) Inventor: BOTARI, Tiago, 5500 AH Veldhoven (NL); ONOSE, Alexandru, 5500 AH Veldhoven (NL); TRAJANOSKA, Marija, 5500 AH Veldhoven (NL); PISARENCO, Maxim, 5500 AH Veldhoven (NL); KIEHN, Moritz, Simon, Maria, 5500 AH Veldhoven (NL); KUIPER, Vincent, Sylvester, 5500 aH Veldhoven (NL)
(74) Representative: ASML Netherlands B.V.

(57) **Abstract**

A data processing method for image data obtained by scanning a charged particle beam across a sample; the method comprising:
classifying pixels of the image data into foreground pixels and background pixels to generate a foreground pixel map; and
encoding the foreground pixel map as encoded data using a sparse matrix encoding technique.

## Description

### FIELD

The embodiments provided herein generally relate to data processing methods, charged particle assessment systems and methods of operating charged particle assessment systems.

### BACKGROUND

When manufacturing semiconductor integrated circuit (IC) chips, undesired pattern defects, as a consequence of, for example, optical effects and incidental particles, inevitably occur on a substrate (i.e. wafer) or a mask during the fabrication processes, thereby reducing the yield. Monitoring the extent of the undesired pattern defects is therefore an important process in the manufacture of IC chips. More generally, the assessment (for example the inspection and/or measurement) of a surface of a substrate, or other object/material, before, during and/or after manufacturing steps of the surface is an important process.

Pattern inspection apparatuses with at least one charged particle beam have been used to inspect objects, which may be referred to as samples, for example to detect pattern defects. These apparatuses typically use electron microscopy techniques, such as a scanning electron microscope (SEM). In some SEMs, a primary electron beam of electrons at a relatively high energy is targeted with a final deceleration step in order to land on a sample at a relatively low landing energy. The beam of electrons is focused as a probing spot on the sample. The interactions between the material structure at the probing spot and the landing electrons from the beam of electrons cause signal electrons to be emitted from the surface, such as secondary electrons, backscattered electrons or Auger electrons. The signal electrons may be emitted from the material structure of the sample. By scanning the primary electron beam as the probing spot over the sample surface, signal electrons can be emitted across the surface of the sample. By collecting these emitted signal electrons from the sample surface, a pattern inspection apparatus may obtain an image representing characteristics of the material structure of the surface of the sample. Assessment systems exist with a detector having a single detector or an array of many detector elements and/or with a single beam or many tens, hundreds or thousands of beams.

When such assessment apparatuses, such as a pattern inspection apparatus for detecting defects, are used to assess samples at a high throughput, image data is generated at very high rates for example by the many detector elements. Large amounts of computing power, data storage and/or communication bandwidth are required to process such data.

### SUMMARY

It is an object of the present disclosure to provide embodiments that enable reductions in requirements for computing power, data storage and/or communication bandwidth to process image data from an assessment apparatus, such as a pattern inspection apparatus.

According to a first aspect of the invention, there is provided a data processing method for image data obtained by scanning a charged particle beam across a sample; the method comprising:
classifying pixels of the image data into foreground pixels and background pixels to generate a foreground pixel map; and
encoding the foreground pixel map as encoded data using a sparse matrix encoding technique.

According to a second aspect of the invention, there is provided an assessment method comprising:
directing a charged particle beam onto a sample;
generating a digital detection signal of pixel values in response to signal particles from the sample;
scanning the sample and the charged particle beam; and
processing the digital detection signal using the method described above.

According to a third aspect of the invention, there is provided a data encoding device for encoding image data obtained by scanning a charged particle beam across a sample, the device comprising:
a classifier for classifying pixels of the image data into foreground pixels and background pixels to generate a foreground pixel map; and
an encoder for encoding the foreground pixel map as encoded data using a sparse matrix encoding technique.

According to a fourth aspect of the invention, there is provided a data comparison device for detecting candidate defects in an image of a sample, the device comprising:
an interface for receiving encoded sample data representing a foreground pixel map encoded using a sparse matrix encoding technique; and
a comparator for comparing the encoded sample data to encoded reference data, the encoded reference data representing a foreground pixel map derived from a reference image and encoded using the sparse matrix encoding technique.

According to a fifth aspect of the invention, there is provided a method of processing detection data of a sample surface from a detector element of a detector array, the method comprising:
scanning a charged particle beam across a sample region
detecting resulting signal particles using one or more detector elements of a charged particle detector array to obtain detection data;

receiving pixels of detection data in a data stream from the detector element;
in the datastream classifying pixels of the detection data into foreground pixels and background pixels to generate a foreground pixel dataset representative of the scanned sample region.

### BRIEF DESCRIPTION OF FIGURES

The above and other aspects of the present disclosure will become more apparent from the description of exemplary embodiments, taken in conjunction with the accompanying drawings.
**FIG. 1** is a schematic diagram illustrating an exemplary charged particle beam inspection system.
**FIG. 2** is a schematic diagram illustrating an exemplary multi-beam charged particle assessment apparatus that is part of the exemplary charged particle beam inspection system of **FIG. 1**.
**FIG. 3** is a schematic diagram illustrating an exemplary arrangement having a detector module and a datapath for transmitting data from the detector module to a data processing apparatus external, for example, to a charged particle assessment device.
**FIG. 4** illustrates a classification procedure of an embodiment.
**FIG. 5** illustrates a comparison process of an embodiment.
**FIG. 6** is a schematic diagram of a data processing system according to an embodiment.

The schematic diagrams and views show the components described below. However, the components depicted in the figures are not to scale.

### DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses and methods consistent with aspects related to the invention as recited in the appended claims.

The enhanced computing power of electronic devices, which reduces the physical size of the devices, can be accomplished by significantly increasing the packing density of circuit components such as transistors, capacitors, diodes, etc. on an IC chip. This has been enabled by increased resolution enabling yet smaller structures to be made. For example, an IC chip of a smart phone, which is the size of a thumbnail and available in, or earlier than, 2019, may include over 2 billion transistors, the size of each transistor being less than 1/1000th of a human hair. Thus, it is not surprising that semiconductor IC manufacturing is a complex and time-consuming process, with hundreds of individual steps. Errors in even one step have the potential to dramatically affect the functioning of the final product. The goal of the manufacturing process is to improve the overall yield of the process. For example, to obtain a 75% yield for a 50-step process (where a step can indicate the number of layers formed on a wafer), each individual step must have a yield greater than 99.4%. If each individual step had a yield of 95%, the overall process yield would be as low as 7%.

While high process yield is desirable in an IC chip manufacturing facility, maintaining a high substrate (i.e. wafer) throughput, defined as the number of substrates processed per hour, is also essential. High process yield and high substrate throughput can be impacted by the presence of a defect. This is especially true if operator intervention is required for reviewing the defects. Thus, high throughput detection and identification of micro and nano-scale defects by inspection devices (such as a Scanning Electron Microscope (`SEM')) is essential for maintaining high yield and low cost.

An embodiment of a SEM comprises a scanning device and a detector apparatus. The scanning device comprises an illumination apparatus that comprises an electron source, for generating primary electrons (or charged particles), and a projection apparatus for scanning a sample, such as a substrate, with one or more focused beams (or a plurality of beams) of primary electrons. The plurality of beams may be arranged as a multi-beam. The plurality of beams may have a multi-beam arrangement (which may have the form of a grid) which may be directed along a multi-beam path towards a sample. Together at least the illumination apparatus, or illumination system, and the projection apparatus, or projection system, may be referred to together as the electron-optical system or apparatus. The primary electrons interact with the sample and generate secondary electrons. The detection apparatus captures the secondary electrons from the sample as the sample is scanned so that the SEM can create an image of the scanned area of the sample. For high throughput inspection, some of the inspection apparatuses use multiple focused beams, i.e. a multi-beam, of primary electrons. The component beams of the multi-beam may be referred to as sub-beams or beamlets. A multi-beam can scan different parts of a sample simultaneously. A multi-beam inspection apparatus can therefore inspect a sample at a much higher speed than a single-beam inspection apparatus.

An implementation of a known multi-beam inspection apparatus is described below.

While the description and drawings are directed to an electron-optical system, it is appreciated that the embodiments are not used to limit the present disclosure to specific charged particles. References to electrons throughout the present document may therefore be more generally be considered to be references to charged particles, with the charged particles not necessarily being electrons.

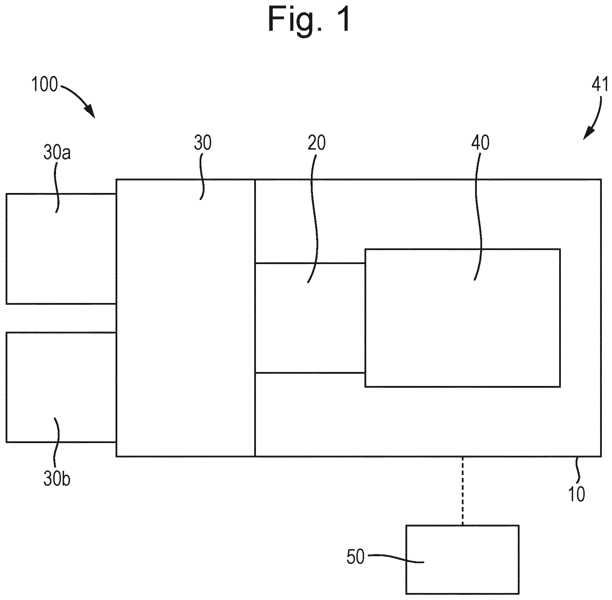

Reference is now made to **FIG. 1**, which is a schematic diagram illustrating an exemplary charged particle beam assessment system 100 (or simply an assessment system), which may also be referred to as a charged particle beam inspection system or simply inspection system or a charged particle metrology system or simply a metrology system. The charged particle beam assessment system 100 of **FIG. 1** includes a main chamber 10, a load lock chamber 20, an electron beam system 40, an equipment front end module (EFEM) 30 and a controller 50. The electron beam system 40 is located within the main chamber 10.

The EFEM 30 includes a first loading port 30a and a second loading port 30b. The EFEM 30 may include additional loading port(s). The first loading port 30a and the second loading port 30b may, for example, receive substrate front opening unified pods (FOUPs) that contain substrates (e.g., semiconductor substrates or substrates made of other material(s)) or samples to be inspected (substrates, wafers and samples are collectively referred to as "samples" hereafter). One or more robot arms (not shown) in the EFEM 30 transport the samples to the load lock chamber 20.

The load lock chamber 20 is used to remove the gas around a sample. This creates a vacuum that is a local gas pressure lower than the pressure in the surrounding environment. The load lock chamber 20 may be connected to a load lock vacuum pump system (not shown), which removes gas particles in the load lock chamber 20. The operation of the load lock vacuum pump system enables the load lock chamber to reach a first pressure below the atmospheric pressure. After reaching the first pressure, one or more robot arms (not shown) transport the sample from the load lock chamber 20 to the main chamber 10. The main chamber 10 is connected to a main chamber vacuum pump system (not shown). The main chamber vacuum pump system removes gas particles in the main chamber 10 so that the pressure in around the sample reaches a second pressure lower than the first pressure. After reaching the second pressure, the sample is transported to the electron beam system by which it may be inspected. An electron beam system 40 may comprise a multi-beam electron-optical apparatus (which may be referred to an electron-optical column or (on occasion) electron-optical device).

The controller 50 is electronically connected to electron beam system 40. The controller 50 may be a processor (such as a computer) configured to control the charged particle beam assessment apparatus 100. The controller 50 may also include circuitry which may be referred to as processing circuitry configured to execute various signal, data and image processing functions. While the controller 50 is shown in **FIG. 1** as being outside of the structure that includes the main chamber 10, the load lock chamber 20, and the EFEM 30, it is appreciated that the controller 50 may be part of the structure. The controller 50 may be located in one of the component elements of the charged particle beam inspection apparatus or it can be distributed over at least two of the component elements. While the present disclosure provides examples of the main chamber 10 housing an electron beam system, it should be noted that aspects of the disclosure in their broadest sense are not limited to a chamber housing an electron beam system. Rather, it is appreciated that the foregoing principles may also be applied to other devices, and other arrangements of apparatus, that operate under the second pressure. For example the controller may be a distributed controller having one or more parts at the second pressure, optionally with one more parts at the first pressure.

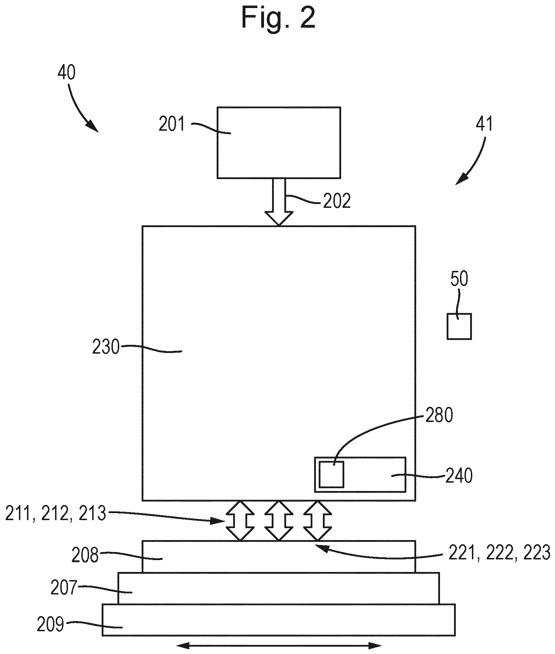

Reference is now made to **FIG. 2**, which is a schematic diagram illustrating an exemplary electron beam system 40, including a multi-beam electron-optical system 41 (or electron optical device), that is part of the exemplary charged particle beam assessment apparatus 100 of **FIG. 1**. The electron beam system 40 comprises an electron source 201 and a projection apparatus 230. The electron beam system 40 further comprises an actuated stage 209 and a sample holder 207. The electron source 201 and projection apparatus 230 may together be referred to as the electron-optical system 41 or as an electron-optical column. The sample holder 207 is supported by actuated stage 209 so as to hold a sample 208 (e.g., a substrate or a mask) for inspection. The multi-beam electron-optical system 41 further comprises a detector 240 (e.g. an electron detection device). It should be noted that although an electron beam system comprising a multi-beam electron-optical system is described, it is only an embodiment of the invention. The invention disclosed herein may be applied to an electron beam system with a single beam electron-optical system, for example for projecting a single beam of electrons towards a sample.

The electron source 201 may comprise a cathode (not shown) and an extractor or anode (not shown). During operation, the electron source 201 is configured to emit electrons as primary electrons from the cathode. The primary electrons are extracted or accelerated by the extractor and/or the anode to form a primary electron beam 202.

The projection apparatus 230 is configured to convert the primary electron beam 202 into a plurality of sub-beams 211, 212, 213 and to direct each sub-beam onto the sample 208. Although three sub-beams are illustrated for simplicity, there may be many tens, many hundreds, many thousands for example approximately ten thousand, many tens of thousands or many hundreds of thousands of sub-beams. A larger number of sub-beams may exist in a charged particle beam system 40 comprising a plurality of charged particle optical systems 41; each charged particle optical system may project many sub-beams, for example several thousand beams, towards a sample. The sub-beams may be referred to as beamlets. A charged particle beam system 40 comprising a plurality of charged particle optical systems 41 may be referred to as a multi-column system.

The controller 50 may be connected to various parts of the charged particle beam assessment apparatus 100 of **FIG. 1**, such as the electron source 201, the detector 240, the projection apparatus 230, and the actuated stage 209 (e.g. a motorized stage). The controller 50 may perform various image and signal processing functions. The controller 50 may also generate various control signals to govern operations of the charged particle beam inspection apparatus, including the charged particle multi-beam apparatus.

The electron-optical apparatus 230 may be configured to focus sub-beams 211, 212, and 213 onto a sample 208 for inspection and may form probe spots 221, 222, and 223 (for this example three probe spots, one for each sub-beam) on the surface of sample 208. The projection apparatus 230 may be configured to deflect the primary sub-beams 211, 212, and 213 to scan the probe spots 221, 222, and 223 across individual scanning areas in a section of the surface of the sample 208. In response to incidence of the primary sub-beams 211, 212, and 213 on the probe spots 221, 222, and 223 on the sample 208, electrons are generated from the sample 208 which include secondary electrons and backscattered electrons which may be referred to as signal particles. The secondary electrons typically have electron energy less than or equal to 50 eV. Actual secondary electrons can have an energy of less than 5 eV, but anything beneath 50 eV is generally treated at a secondary electron. Backscattered electrons typically have electron energy between 0 eV and the landing energy of the primary sub-beams 211, 212, and 213. As electrons detected with an energy of less than 50 eV are generally treated as secondary electrons, a proportion of the actual backscatter electrons will be counted as secondary electrons.

The detector 240 is configured to detect signal particles such as secondary electrons and/or backscattered electrons and to generate corresponding signals which are sent to a signal processing device 280 for pre-processing, e.g. analog to digital conversion. (The signal processing device 280 may be distributed in a plurality of different devices which may be referred to together as a signal processing system.) The detector 240 may be incorporated into the projection apparatus 230. Further details and alternative arrangements of a detector module, sensor and detector array positioned proximate to, up beam, down beam or otherwise integrated into an objective lens can be found in EP Application Number 20216890.2 and PCT Application number PCT/EP2021/068548, which documents are respectively hereby incorporated by reference at least in so far as they disclose details of the detector module, sensor and detector array and similar elements.

The detector may be provided with multiple portions and more specifically, multiple detecting portions (such as detector elements). The detector comprising multiple portions may be associated with one of the sub-beams 211, 212, 213. Thus, the multiple portions of one detector 240 may be configured to detect signal particles emitted from the sample 208 in relation to one of the primary beams (which may otherwise be referred to as sub-beams 211, 212, 213). In other words, the detector comprising multiple portions may be associated with one of the apertures in at least one of the electrodes of the objective lens assembly. The multiple portions may be segments are arranged radially and/or angularly. More specifically, the detector comprising multiple portions may be arranged around a single aperture, which provides an example of such a detector.

As mentioned, the detection signal from the detector module is used to generate an image. With multiple detecting portions, the detection signal comprises components from the different detecting signals that may be processed as data sets or as a detection image. Between the detector and an external device such as controller 50, or another processor, there may be signal conduits (or a datapath). The signal conduits may be for a datastream. The signal processing device 280 may be comprised within the signal conduits. Many different detection signals, which may correspond to a data signal for each detecting portion, may be transmitted through the signal conduits. Together the data signals comprise the datasteam. Considering there may be many sub-beams, even many thousands of sub-beams from different charged particle optical systems in a charged particle beam system 40 comprising a plurality of charged particle optical systems 41, the data load generated by the detector may large. Note: in an embodiment having a single beam charged particle system, the detector may comprises many detector portions each outputting a respective detection signal. Further, in an embodiment, charged particle beam system 40 may comprise a plurality of single beam charged particle optical systems.

The objective lens may an objective lens array and may comprise a plurality of planar electrodes or plates comprising apertures for the respective paths of the beams of the multi-beam. Each plate may extend across the multibeam arrangement. The objective lens, for example as an objective lens array may comprise at least two electrodes that may be connected to and controlled respective potentials. There may be additional plates each to control an additional degree of freedom. The detector may be a plate that is part of, associated with or connected to the objective lens with an aperture for each path of a beam of the multi-beam. The detector may be located above, below or within the objective lens (or specifically the objective lens array).

A scan deflector may be associated with or even integrated into the objective lens for example as an array of scan deflectors. An array of scan deflectors may be referred to as a deflector array may for example be integrated into the objective lens array. In an arrangement the scan deflector may be positioned up beam of the object lens. In an arrangement in which the path of the primary beams are collimated up beam of the objective lens, the scan deflectors may be positioned up beam of the objective lens. In an arrangement in which the multibeam is generated from a collimated primary beam from a source by a beam limiting aperture array of or associated with the objective lens, the scan deflector may be a macro scan deflector positioned up beam of the objective lens and so as to operate on the collimated primary beam. Other electron-optical arrangements may be envisaged comprising one or more elements herein described. Such scan deflectors may be controlled by the controller to deflect the beams of the multi-beam along one axis in the plane of the sample or both primary axes over the surface of a sample e.g. in the plane of the sample (which may be orthogonal with respect to each other).

It should be noted that embodiments of scan deflectors that are proximate to the sample, for example integrated or proximate to the objective lens, may have a limited range of scan deflection. However scan deflectors proximate to the sample may be accurately controlled and have a fast response relative to other types of scanning actuators such as an actuated stage.

The controller 50 may control the actuated stage 209 to move sample 208 during inspection of the sample 208. The controller 50 may enable the actuated stage 209 to move the sample 208 in a direction, preferably continuously, for example at a constant speed, at least during sample inspection, which may be referred to as a type of scanning. The speed of the actuated stage may be referred to as the moving rate. The controller 50 may control movement of the actuated stage 209 so that it changes the speed of the movement of the sample 208 relative to the path of the multi-beam dependent on various parameters. The controller 50 may control deflection of the scan deflectors so that the path of the multibeam moves relative to the stage and thus over the sample surface. The controller 50 may change a beam deflection of the scan deflector and thus the scanning of the beams over the sample surface dependent on various parameters. For example, the controller 50 may control the stage speed (including its direction) and/or scan deflector depending on the characteristics of the inspection scanning elements and steps, for example in the scanning process and/or scans of the scanning process as disclosed in EPA 21171877.0 filed 3 May 2021. The content of such application is hereby incorporated in so far as it discloses a combined stepping and scanning strategy at least of the stage and scanning deflectors. Thus, the moving rate may at different times comprise a stepping frequency and/or a stage scanning rate.

To obtain a two-dimensional image of the sample, the (or each) probe beam is scanned across the surface of the sample in a two-dimensional raster pattern. This involves movement of the beam in two directions: a main scanning direction and a sub-scanning direction which have different orientations, e.g. are orthogonal. The main scanning direction may be referred to as the fast scan direction. For example the scan deflector may be controlled to actuate the primary beam (e.g. multi-beam) in the fast direction. The sub-scanning direction may be referred to as the slow scan direction. For example the stage may be controlled to actuate the sample relative to the path of the primary beam; the scan deflector may be controlled to actuate the path of the beam over the sample surface in the slow direction; or both the stage and the scan deflector are actuated to achieve scanning in the slow direction. The stage is preferred to be used only in the slow direction because its inertia due to its large mass makes achieving the movement of scanning in the fast direction, e.g. acceleration, more challenging than alternatives such as a scan deflector.

Known multi-beam systems, such as the electron beam system 40 and charged particle beam assessment apparatus 100 described above, are disclosed in US2020/118784, US202002/03116, US2019/0259564 and WO2021078352 which are hereby incorporated by reference at last so far as the electron beam system and/or the charged particle beam assessment apparatus.

The electron beam system 40 may comprise a projection assembly to regulate accumulated charges on the sample by illuminating the sample 208.

Data output from a charged particle assessment apparatus, e.g. electron beam system 40, are desirably processed by a data processing device automatically to detect defects in samples being assessed. The data processing device, or at least a part of the data processing device, may be part of controller 50, part of another computer in the fab or integrated elsewhere in the charged particle assessment apparatus.

In a charged particle inspection system, the or each electron-optical system 41 is located within main (vacuum) chamber 10. It is therefore necessary to transmit data from the electron-optical system(s) to devices or other components outside the vacuum chamber such as controller 50. Raw data generated by the electron optical system(s) can be transmitted out of the vacuum chamber via signal conduits. Considering the quantity of data, the data may be optically transmitted, for example using optically capable signal conduits such as optic fibers. An optical transceiver is used to convert the electrical signals representative to the data to optical signals. The optical transceiver is located near the detector module 240 of the electron optical system 41. The optical transceiver is configured to convert the electrical signals output by the detector module 240 to optical signals for transmission along an optical fiber. The optical fiber may be capable of transmitting multiple channels simultaneously (e.g. using different wavelengths). Thus the detection signals from each individual electrode of the detector module are converted into an appropriate number of data streams. Multiple optical fibers, either as single channel or multi-channel optic fibers, can be used.

The or each signal conduit, e.g. optical fiber, passes through the wall of main chamber 10 (inside of which is at vacuum in use) by a vacuum feedthrough 11. A suitable vacuum feedthrough is described in US2018/0182514 A1 which document is incorporated herein by reference at least insofar as it relates to a feedthrough device. The signal conduit, e.g. optical fiber, is connected to data processing device 50, which can therefore be located outside the vacuum for ease of access and to avoid needing to increase the size of the vacuum chamber to accommodate the data processing device. In both single-column and multi-column systems, multiple optical transceivers and multiple optical fibers per column may be used if convenient.

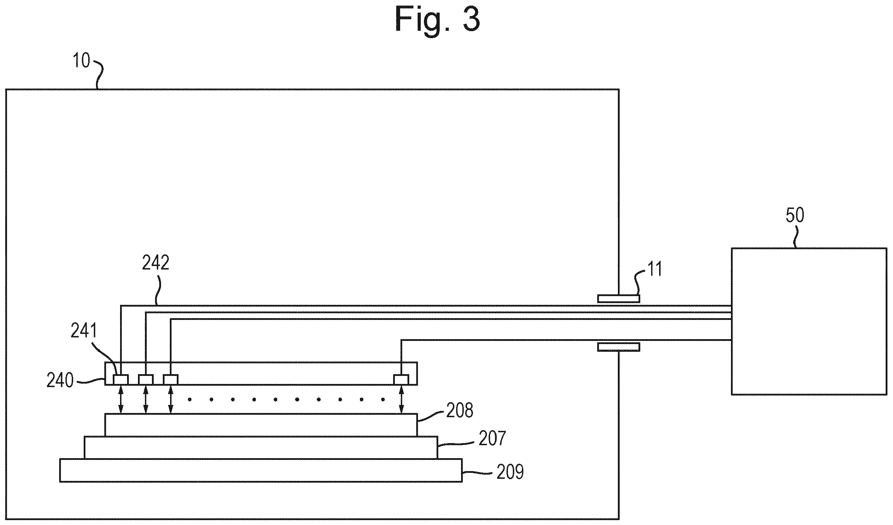

An arrangement involving multiple optical fibers (or other communication channels) is shown in **FIG.** 3. Each optical fiber 242 is connected to a sub-unit (or detector unit) 241 of the detector module 240 and transmits signals generated by the respective sub-unit 241 to the data processing device 50 which is external to the main chamber 10. Each sub-unit 241 may include one or more individual electrodes of the detector module 240. It will be seen that in a multi-column system that is capable of imaging a large portion of the sample 208 at a time, there will need to be a large number of optical fibers 242 and hence vacuum feedthrough 11 must be large. As well as taking up space, a large vacuum feedthrough, or multiple smaller feedthroughs, can be difficult to seal.

Various approaches may be taken to detect defects in images generated by a charged particle assessment apparatus. A common approach is to compare an image of a part of the sample, referred to herein as a sample image, to one or more reference images. In practice, data points of a datastream representing the sample image are compared to data points of the reference image retrieved from a memory or delivered in a parallel datastream. For the sake of brevity, this process may be referred to below as comparing images; the data points may be referred to as pixels. As mentioned above, a high-throughput assessment apparatus (i.e. that generates many simultaneous detection signals), e.g. a multi-beam or multi-column assessment apparatus, generates data at a very high rate so that a pixel by pixel comparison requires a very high bandwidth data communication path to get data out of the assessment apparatus and/or a large amount of computing resource to perform the comparison. A two stage defect detection process has been proposed, whereby an initial comparison of sample data is carried out to locate candidate defects and then "clips" (regions of image data surrounding the candidate defect) are transmitted to an external data processing system for more detailed analysis. However, even such a process requires a large amount of computing resource to perform the initial comparison in a high throughput assessment apparatus.

More generally, in a charged particle assessment device, especially one using multiple charged particle beams, it often is desirable to perform some initial data processing on the very large amounts of data that are generated. For example, it may be desirable to reduce noise, compress and/or encode the data to reduce the bandwidth and/or computational load. Such initial data processing may be performed wholly or partially within the charged particle assessment device (for example within the vacuum chamber of the charged particle assessment apparatus, or even in a detector module of the charged particle assessment apparatus). Such processing may be inline, that is applied to the detection signal optionally without buffering, such as in the datapath from the detector module (e.g. from the detector or even the detector elements) to an external processor elsewhere in the charged particle apparatus or external to the charged particle assessment system, such as remote data rack.

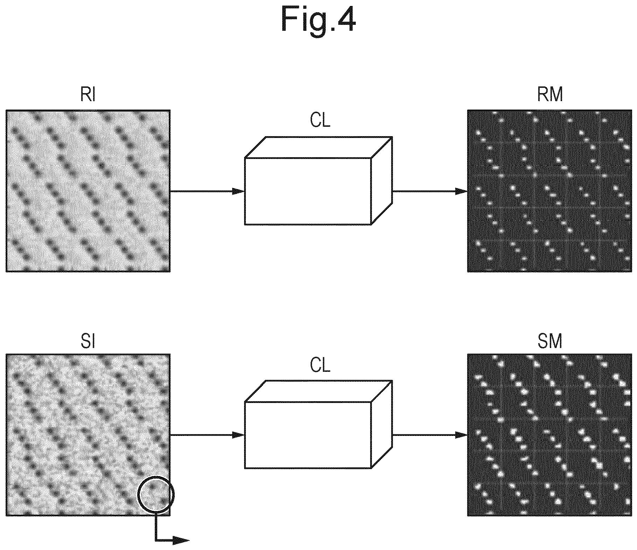

A method of assessing samples according to an embodiment is described below with reference to **FIGs. 4 to 6**. At a high level, a two-stage process is performed.

In a first stage as depicted in **FIG. 4**, the sample image output by a detector in a charged-particle assessment apparatus is subjected to a classification process, locally to the detection, to identify foreground and background regions of the sample image and generate a foreground pixel map (or more generally a foreground pixel data set - the data set might have a structure which does not directly correspond to a 'map'; where a map directly provides relative position information of the foreground regions). The foreground pixel map can then be subject to a first step to create encoded data that is a compressed representation of the sample image. The first step may be an encoding or compression step. The first step may be considered to be a data encoding step. The encoded data may correspond to features in the data. The encoding may be considered to be feature encoding. The first step may be achieved using a sparse matrix encoding technique. The encoded data is in a high efficiency compressed representation of the sample image. That is, a high compression ratio is applied to the data such that it is a compressed representation of the sample image. A reference image is also subject to the same classification and encoding process, not necessarily local to the detector nor contemporaneously with the generation of the sample image.

The first step is depicted in **FIG. 4** which shows the multi-valued sample image SI and reference image RI transformed by classifier CL into a two-level sample map SM and a two-level reference map RM respectively which are the compressed representations. Each of the two-level maps represents foreground and background regions (e.g. pixels) and may be referred to as a binary map, having one bit per pixel. Note, the use of two levels in the embodiments shown in and described with reference to **FIG. 4** is exemplary. As many levels may be used as desired, such three or more and/or in the range of two to ten levels. The number of levels may correspond to the different types of features (i.e. represented by the corresponding pixels) required to be evident in the encoded data. Where the map has three or more levels, typically the foreground pixels may be of two or more classes; that is the pixels may be classified into background pixels and at least two different classes of foreground pixels (or foreground pixel classes). Additionally or alternatively, there may be more than one background class of pixels.

The first stage processing depicted in **FIG. 4** may be considered a form of feature encoding in which different types of features are converted to a data structure of lower density than the data structure of the raw detection signal. Such processing may occur without applying any defect detection processing, as such. The encoded data provides data from which the detects are later identified. This is distinct from another process in which the detection signals are processed for an initial identification of candidate defects in which only data relating to the candidate defects, e.g. image clips, need to be transmitted out of the charged particle assessment device for further analysis.

In any event, by application of the present invention to an embodiment, the amount of data that is output from the charged particle assessment device is greatly reduced by the reduced data structure, desirably such that throughput-limitations of data transmission rates are reduced, if not eliminated.

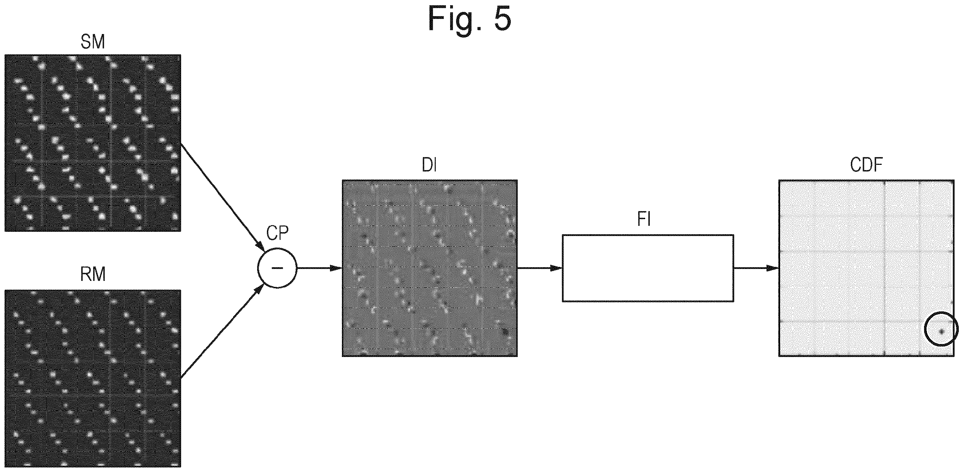

In a second stage, depicted in **FIG. 5**, the compressed representations SM, RM of the sample image and the reference image are compared by comparator CP to identify defects in the sample image. In an embodiment, the comparison process may comprise a subtraction of the compressed representations of the sample and reference images to generate a difference image DI. The difference image DI may be subjected to filtering and/or thresholding by filter FI to eliminate false positives and obtain a candidate defect file CDF.

In more detail, the classification step of the first stage may simply classify pixels into foreground and background, thus reducing the data output to a binary bitmap as the foreground pixel map, which is a significant reduction in the data volume in and of itself. What is foreground and background may depend on the nature of the pattern undergoing inspection. For example, a foreground pixel may be a pixel at the location of a line or contact hole whilst other pixels are background pixels. In general, foreground pixels may represent a selected type of topography, surface material or any other characteristic of the sample being assessed that can be distinguished in the detection signal. For example, one class of foreground pixel may be a so-called "soft defect", that is a part of the substrate where the surface parameter (e.g. height) represented by the detector intensity signal is between the values expected for a feature and for background. A soft defect may represent an improperly formed feature. An example of a soft defect is a "bridge defect" in which undesired structures are formed between two desired features. It will be appreciated that in some cases a foreground pixel may be a pixel where the detector intensity signal is high but in other cases it will be a pixel whereby the detector intensity signal is low, depending on the type of feature considered to be foreground. Thus where a threshold is used to classify pixels into foreground or background, a foreground pixel can, in different assessment recipes, be either a pixel having a detector signal lower than the threshold or a pixel having a detector signal higher than the threshold.

In some cases, there may be several different classes of foreground pixel, which can be referred to as subclasses. For example where more than one threshold is used to identify different classes of foreground pixel. In an embodiment, the different classes of foreground pixels are combined into a single multi-valued map as the foreground pixel map (or more generally a foreground pixel data set). In an embodiment, separate binary maps are created for each class of pixel so that the foreground pixel map comprises multiple binary maps. Whether one multi-valued map or several binary maps is preferred may depend on the number of maps and the number of foreground pixels in each map as well as the encoding and comparison techniques employed. Desirably the number of foreground classes is small, e.g. less than 15 (a 4-bits per pixel map), desirably 7 or less (a 3-bits per pixel map), desirably 3 or less (a 2-bits per pixel map). Conveniently, a foreground pixel may be represented as a binary "1" and a background pixel as a binary "0" but the opposite notation is also useful.

Encoding the foreground pixel map enables a further significant reduction in the volume of data used to represent the foreground pixel map. This may enable a larger dataload of detection signals to be managed without increasing the processing power and memory requirements for managing the detection data of systems having many separate detection elements each of which may generate a different detection signal. Desirably a lossless encoding technique is used. Suitable techniques include:
- dictionary of keys
- List of lists
- Coordinate list
- Compressed sparse row
- Compressed sparse column
- Run-length encoding

In general, the ratio of foreground pixels to total pixels prior to classification is low. For example the number of foreground pixels may be less than the square root of the total number of pixels. So a small number foreground pixels are likely to be selected, hence the ratio of foreground pixels to total pixels is low. A sparse matrix or system is one in which advantage can be taken of the percentage and/or distribution of zero elements. In the present applications, the proportion of the data in which a defect is expected to be detected is very small. In some use cases, it is intended that hardly any or even no defects are detected. As a consequence a defect is expected in only a small number foreground pixels (which are only a small proportion of the total number of pixels). In such a case, sparse matrix encoding techniques are particularly advantageous and may provide very high levels of compression in the compressed representation of the foreground pixel map. In particular, if there is only one class of foreground pixel, or multiple classes of foreground pixel maps are encoded as separate binary bitmaps, a sparse matrix encoding technique can be further reduced to encode only the locations of the foreground pixels, with no need to encode a value for each pixel. Encoding techniques may be chosen or adapted to the pattern to be assessed and defined in the assessment recipe. For example, for a pattern of contact holes, foreground pixels may be expected to be present in clusters of a predictable shape so that it is only necessary to encode the locations of the clusters and deviations from the predicted shape. A pattern having mostly rectangular features may be efficiently encoded by transmitting the locations of opposite corners of a rectangular shape, or one corner and dimensions.

Classification of the detector signal into foreground and background pixels may be performed by means of a comparator that compares the detector signal to a threshold on a pixel by pixel basis. The threshold may be predetermined, e.g. as part of the assessment recipe for a specific device pattern. Where multiple foreground classes are used, multiple thresholds may be employed. In some cases, classification may take into account additional factors than the detection signal value corresponding to a single pixel. For example, adjacent pixel values may also be taken into account.

A noise reduction process may be applied to the foreground pixel map, e.g. prior to or in the process of encoding. A noise reduction technique may eliminate isolated foreground pixels. In most applications, a feature of interest will be larger than a single pixel, hence an isolated pixel is more likely to be noise than a feature. Reduction, if not elimination, of noise before or in the encoding technique may further reduce the volume of data to be transmitted.

The classification and encoding steps are suitable for implementation by dedicated hardware, e.g. an FPGA or an ASIC. Such dedicated hardware can be more efficient and economic than programmed general purpose computing devices, e.g. CPUs. Some parts of the process may be performed by simple electronic circuits that can be placed in a signal processing substrate of a detector module. Such electronic circuits may include analog elements, such as a variable threshold circuit. The processors of dedicated hardware may be used as intended; whereas part of the functionality of a general purpose computing device (e.g. a CPU) may not be required for the intended processing and may be unused and redundant. Dedicated hardware such as an FPGA or an ASIC can be integrated into the detector circuitry or placed in the main (vacuum) chamber close to the electron-optical column. In this way, the volume of data to be transmitted outside of the main chamber can be significantly reduced, e.g. by one or more orders of magnitude. Such a significant reduction of data volumes enables a corresponding significant reduction in the number of signal conduits and the size of the vacuum feedthrough. Conversely, data reduction enables the number of detector elements to be increased (and optionally the number of data signals from the detector and/or signal conduits such as prior to the feedthrough) without increasing the number or effective size of the feedthrough. The classification and encoding steps can be carried out in the image data using many dedicated circuits in parallel, enabling the classification and encoding to be carried out at a high rate, e.g. matching the rate of data generation of the detector. Hence the need for buffering of data is reduced or eliminated. However, as discussed below, some short term buffering of the detector signal may be desirable in some cases.

It will be appreciated that the classification and encoding of the reference image can be carried out off-line and in advance of an assessment process so that there are no particular constraints on the timing and manner of the classification and encoding. The origin of the reference image is also not particularly limited. For example, the reference image may be obtained from GDSII data of the device pattern that is being assessed. Alternatively, the reference image may be obtained by scanning a reference. If the reference image is obtained by scanning, the scan may be performed at a higher fidelity (e.g. at a slower speed) or may be obtained by averaging scans of multiple references.

In a different embodiment, another scanned image scanned under the same conditions as the image being assessed may be used as a reference. It is desirable when using such an image, or indeed any scanned image, to determine the presence of defects using two refence images derived from two different scanned images; such a defect detection process may be referred to a die-to-die inspection. The benefit of this process is that any likely defects determined by comparison of the sample image with respect to one of the reference scanned images can be verified as being a defect. It is possible that a reference image may have a defect. Comparison of the sample image to a first reference image determines a difference image and set of likely defects. This difference image may be compared to either a second difference image obtained by comparing the sample image with respect to the second reference image, or to a reference difference image determined by a comparison of the two reference images. Any differences present in the two difference images may indicate a likely defect that is not a defect, but which appears to be a defect present on one of the reference images. Similarly, a likely defect revealed to be present in the difference image and the reference difference image indicates the presence of defect present in one of the refence images but not the sample image. Using the present invention, the comparisons between the scanned image and the two reference images may be achieved with the data sets representing the sample image and the two reference images classified and encoded.

Referring again to **FIG. 5**, the second stage of comparing the encoded sample image to an encoded reference image may comprise a simple subtraction of the encoded foreground pixel map of the sample image (referred to below as the sample foreground pixel map) from the foreground pixel map of the reference image (referred to below as the reference foreground pixel map) (or vice versa) or an XOR operation (which may be considered to be a multiplication operation). Such an operation, e.g. subtraction, will remove foreground pixels that exist in both images, to generate a difference foreground pixel map containing only foreground pixels that exist in one but not the other. Such residual foreground pixels (e.g. of multiple classes when multiple foreground pixels are used) may represent candidate defects, e.g. features that are missing from the test image (e.g. a contact hole that has not printed - indicated by the dashed circle in **FIG. 5**), misshapen, misplaced or erroneous features and soft defects. The operation chosen for comparing the sample image to the reference image may depend on the type of defect looked for.

In some cases it may be desirable to perform filtering or thresholding on the difference foreground pixel map prior to identifying candidate defects. Such filtering may, for example, eliminate defects that are smaller than a predetermined size. Filtering may select one more classes of foreground pixel where multiple classes of foreground pixel are present. Filtering after the comparison may be more necessary if noise reduction was not performed in or before the classifying and encoding steps.

Prior to the comparison of encoded sample image and encoded reference image, it may be desirable to perform an alignment process to determine a global offset between the sample and reference foreground pixel maps. In some cases there may be a misalignment between the sample and reference foreground pixel maps of the order of a few pixels in each direction (e.g. less than 5) which can be detected by known techniques. Such a small offset is easily accommodated in the comparison step. As an alternative approach, the comparison can be carried out multiple times using different offsets and the result with the fewest differences taken to represent correct alignment.

It will be appreciated that, depending on the nature of the encoding of the sample and reference foreground pixel maps, it may not be necessary to convert the sample and reference foreground pixel maps back into a full matrix representation or bitmap. For example, if the sample and reference foreground pixel maps are encoded as ordered lists of foreground pixel locations, a direct comparison of the lists may be performed very easily. In other encoding techniques, e.g. run length encoding, pixel values may be determined on the fly for comparison and do not need to be stored.

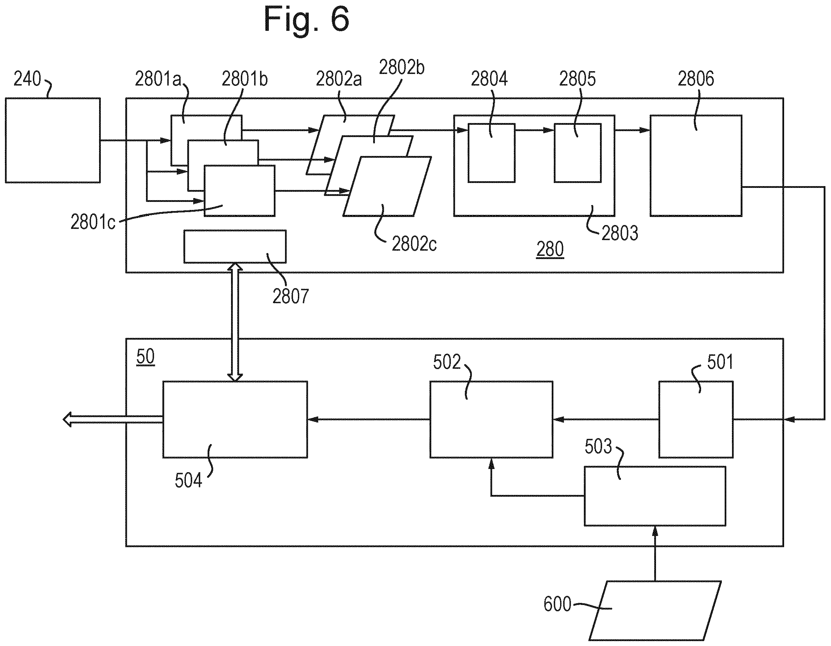

A data processing system comprising a signal processing device 280 and a data processing device 50 will now be described with reference to **FIG. 6**. The detector signal output by detector 240 is received by a signal processing device 280. In an embodiment in which the electron optical system has multiple electron beams, the detector signal may be a separate signal for each beam. In such an arrangement, a separate signal processing device 280 may be provided for each electron beam. (In an embodiment the signal processing device 280 may comprise a plurality of signal processing elements assigned to different detector signals, for example derived from different electron beams. The different signal processing elements may have the features of the signal processing device elsewhere herein described.) Desirably, the detector signal is a multi-valued signal representing the intensity of electrons returned from the sample in response to the or each electron beam.

The detector signal is supplied to one or more classifiers 2801a-c in parallel. Each classifier determines whether a given pixel is a foreground pixel, or in the case of multiple classifiers, a specific sub-class of foreground pixel. In an embodiment, each classifier 2801a-c may be a comparator that determines whether the density of the detector signal corresponding to a given pixel is above or below a given threshold or within a given range of values. The thresholds or ranges of values may be determined in an assessment recipe for a specific pattern to be assessed. Alternatively, classifiers 2801a-c may be arranged in series or a cascade format. Whilst three classifiers are shown, it will be appreciated that more or fewer classifiers may be provided according to the number of pixel classes or sub-classes to be identified, which may be a small number of classes such as two classes or as many as ten or fifteen. Each of the classifiers 2801a-c outputs a respective foreground pixel map 2802a-c. As discussed above, each of the foreground pixel maps 2802a-c may be a binary bitmap. Alternatively, the outputs of the classifiers 2801a-c may be combined into a single multi-valued foreground pixel map.

The or each foreground pixel map 2802a-c is then subject to a noise reduction process by noise filter 2803. Noise filter 2803 may comprise an erosion kernel 2804, optionally followed by a dilation kernel 2805. Erosion kernel 2804 reduces the size of regions of foreground pixels within the foreground pixel map by a predetermined amount, e.g. one pixel. Dilation kernel 2805 increases the size of regions of foreground pixels in the foreground pixel map, e.g. by the same amount as the reduction applied by the erosion kernel 2804. The effect of the erosion and dilation operations is that small regions of foreground pixels, e.g. isolated foreground pixels, are eliminated. As discussed above, isolated foreground pixels or small regions of foreground pixels are more likely to represent noise than actual features on the sample.

The or each foreground pixel map is then encoded by encoder 2806 e.g. using a sparse matrix encoding technique as described above. The encoded foreground pixel maps are then transmitted to data processing device 50, e.g. via a vacuum feedthrough.

Data processing device 50 comprises an interface 501 for receiving the encoded foreground pixel maps and performing error correction or the like. A reference interface 503 receives a reference foreground pixel map 600, desirably encoded in the same format as the sample foreground pixel map received by interface 501. Candidate defect detector 502 compares the sample foreground pixel map to the reference foreground pixel map to identify the locations of any candidate defects in the sample. The locations of any candidate defects are passed to output module 504.

Output module 504 receives the results output by candidate defect detector 502 and prepares output to the user, to other fab systems or for further processing within the inspection system. The output may be in any of several different forms. In a simplest option, the output may simply be an indication that the sample has or does not have a defect. However, in some use cases almost all samples will have at least one potential defect more detailed information is desirable, for example as a data set, such as an image (e.g. such as a data set renderable as an image). Therefore the output may comprise, for example, a map of defect locations (or more generally data indicative of the defect and its location in a frame of reference such as an image, or the sample surface), a deviation image, and/or a clip of pixel data (for example of the image and the reference image or of the reference image). Alternatively or in addition, the output may comprise information as to the severity of a possible defect represented by the magnitude of the difference between the sample image and the reference image, for example how the sample image deviates from the reference image. The clip of pixel data may be obtained from a buffer 2807 in the signal processing device that temporarily stores image data derived from the detector signal. The clip may correspond to a portion of an image, and may be derived from data of the sample image and optionally the reference image corresponding to that portion of the sample image).

Output module 504 may also filter the potential defects, e.g. by only outputting defect locations where the magnitude of the difference between the sample image and the reference is greater than a threshold or the density of pixels showing a difference is higher than a threshold. Another possibility is to output only a predetermined number of most serious defect sites, indicated by the magnitude of the difference. This may be effected by storing defect sites in a buffer 510 and, when the buffer is full, overwriting the lowest magnitude defect if a higher magnitude defect is detected.

Any suitable format for the output of defect information may be used, e.g. a list, data set, image or a map. Desirably, output module 504 may output clips, that is images of regions of the sample where potential defects have been detected. This allows the potential defect to be further examined to determine if the defect is real and serious enough to affect operation of the device formed on or present in the sample. The rest of the source image, i.e. those parts not saved as clips, may be discarded to save on data storage and transfer requirements. The data set may thus be a set of clips; the image may comprise the set of clips.

Signal processing device 280 may be remote from a detector array, for example within a vacuum chamber. Signal processing device 280 may be part of an electron-optical assembly of the electron-optical column; such assembly may comprise the detector (such as detector array), and an objective lens (such as an objective lens array). The detector may be in a path of the beam grid and the signal processing device may be away from the path of the beam grid. The signal processing device may be separate from detector, but electrically connected to the detector. Signal processing devices may be used to process data not just signals comprising data direct from a detector. The signal processing device may be used to sort buffered or a saved data file representing previously received detection signals as data. In such a context a signal processing device may be referred to as a data processing device. Although the described embodiment refers to an inline application of the invention, which may be desirable in a system generating significant quantities of data, the invention may be applied after receipt and storage of the detection signals of a portion of a sample surface, such as an image. However, in such an application, the amount of data processed may be reduced, although some or all of the benefits in terms of initial reduction in data load and realization of reduced memory for initial storage of the detection signal from the charged particle system 41, may not be realized.

In an embodiment, at least part of, if not all of, the data processing device 50 is remote from the electron optical column, such as remote from the electron-optical assembly, desirably external to a vacuum chamber comprising the electron-optical column. At least part of the data processing device may be in signal communication with the detector through a feedthrough in a wall of the chamber.

References to upper and lower, up and down, above and below, etc. should be understood as referring to directions parallel to the (typically but not always vertical) up-beam and down-beam directions of the electron beam or multi-beam impinging on the sample 208. Thus, references to up beam and down beam are intended to refer to directions in respect of the beam path independently of any present gravitational field.

The embodiments herein described may take the form of a series of aperture arrays or electron-optical elements arranged in arrays along a beam or a multi-beam path. Such electron-optical elements may be electrostatic. In an embodiment all the electron-optical elements, for example from a beam limiting aperture array to a last electron-optical element in a sub-beam path before a sample, may be electrostatic and/or may be in the form of an aperture array or a plate array. In some arrangements one or more of the electron-optical elements are manufactured as a microelectromechanical system (MEMS) (i.e. using MEMS manufacturing techniques). Electron-optical elements may have magnetic elements and electrostatic elements. For example, a compound array lens may feature a macro magnetic lens encompassing the multi-beam path with an upper and lower pole plate within the magnetic lens and arranged along the multi-beam path. In the pole plates may be an array of apertures for the beam paths of the multi-beam. Electrodes may be present above, below or between the pole plates to control and optimize the electro-magnetic field of the compound lens array.

Although the embodiment described herein is a multi-beam electron-optical system featuring electrostatic electron optics, for example featuring electrode plates with apertures to operate on the different beams on the multi-beam, the assessment system may feature a multibeam electron-optical system comprising magnetic components. For example the electron-optical system may comprise at least one of: a macro magnetic condenser lens which may be set to a non-rotational setting; a stack of electron-optical arrays for fine operation on the beams of the multibeam; a beam limiting aperture array for generating and/or shaping the plurality of beams of the multibeam, which may be a plate up beam of the condenser lens and/or a plate down beam between the condenser lens and the stack of electron optical arrays; a macro magnetic objective lens for projecting the plurality of beams onto a sample and which may feature electrostatic elements; a Wien filter for permitting the primary beams towards the sample and for directing signal particles from the sample towards a detector which may be in a secondary column; and a detector in the secondary column. In another arrangement of an assessment system, the electron-optical system may be designed to project a single beam towards the sample. Such a single beam design may be similar to the multibeam beam electron-optical system featuring a magnetic condenser lens; in a variation the detector is in the main column (i.e. is there is not secondary column or Wien filter) for example facing a sample position and/or between the condenser lens and the objective lens.

The terms "sub-beam" and "beamlet" are used interchangeably herein and are both understood to encompass any radiation beam derived from a parent radiation beam by dividing or splitting the parent radiation beam. The term "manipulator" is used to encompass any element which affects the path of a sub-beam or beamlet, such as a lens or deflector. References to elements being aligned along a beam path or sub-beam path are understood to mean that the respective elements are positioned along the beam path or sub-beam path. References to optics are understood to mean electron-optics.

An assessment tool or assessment system according to the disclosure may comprise apparatus which makes a qualitative assessment of a sample (e.g. pass/fail), one which makes a quantitative measurement (e.g. the size of a feature) of a sample or one which generates an image of map of a sample. Examples of assessment tools or systems are inspection tools (e.g. for identifying defects), review tools (e.g. for classifying defects) and metrology tools, or tools capable of performing any combination of assessment functionalities associated with inspection tools, review tools, or metrology tools (e.g. metro-inspection tools).

Reference to a component or system of components or elements being controllable to manipulate a charged particle beam in a certain manner includes configuring a controller or control system or control unit to control the component to manipulate the charged particle beam in the manner described, as well optionally using other controllers or devices (e.g. voltage supplies) to control the component to manipulate the charged particle beam in this manner. For example, a voltage supply may be electrically connected to one or more components to apply potentials to the components, such as to the electrodes of the control lens array and objective lens array, under the control of the controller or control system or control unit. An actuatable component, such as a stage, may be controllable to actuate and thus move relative to another components such as the beam path using one or more controllers, control systems, or control units to control the actuation of the component.

The methods of the present invention may be performed by computer systems comprising one or more computers. A computer used to implement the invention may comprise one or more processors, including general purpose CPUs, graphical processing units (GPUs), Field Programmable Gate Arrays (FPGAs), Application Specific Integrated Circuits (ASICs) or other specialized processors. As discussed above, in some cases specific types of processor may provide advantages in terms of reduced cost and/or increased processing speed and the method of the invention may be adapted to the use of specific processor types. Certain steps of methods of the present invention involve parallel computations that are apt to be implemented on processers capable of parallel computation, for example GPUs.

A computer used to implement the invention may be physical or virtual. A computer used to implement the invention may be a server, a client or a workstation. Multiple computers used to implement the invention may be distributed and interconnected via a local area network (LAN) or wide area network (WAN). Results of a method of the invention may be displayed to a user or stored in any suitable storage medium. The present invention may be embodied in a non-transitory computer-readable storage medium storing instructions to carry out a method of the invention. The present invention may be embodied in computer system comprising one or more processors and memory or storage storing instructions to carry out a method of the invention.

Functionality provided by the computers and processors such as the controller or control system or control unit may be computer-implemented. Any suitable combination of elements may be used to provide the required functionality, including for example CPUs, RAM, SSDs, motherboards, network connections, firmware, software, and/or other elements known in the art that allow the required computing operations to be performed. The required computing operations may be defined by one or more computer programs. Such computer programs may take the form of multiple computer programs that may be distributed for example implemented by different processors. The one or more computer programs may be provided in the form of media, optionally non-transitory media, storing computer readable instructions. When the computer readable instructions are read by the computer, the computer performs the required method steps. The computer may consist of a self-contained unit or a distributed computing system having plural different computers connected to each other via a network.

The term "image" used herein is intended to refer to any data structure of values wherein each value relates to a sample of a location and the arrangement of values in the array corresponds to a spatial arrangement of the sampled locations. The term "data map" may be used to describe such a data structure. An image may comprise a single layer or multiple layers. In the case of a multi-layer image, each layer, which may also be referred to as a channel, represents a different sample of the locations. The term "pixel" is intended to refer to a single value of the array or, in the case of a multi-layer image, a group of values corresponding to a single location. An image may be stored in any convenient format in a computer-readable storage medium.

Embodiments of the invention are described in the following numbered clauses.

Clause 1. A data processing method for image data obtained by scanning a charged particle beam across a sample; the method comprising: classifying pixels of the image data into foreground pixels and background pixels to generate a foreground pixel map; and encoding the foreground pixel map as encoded data using a sparse matrix encoding technique.

Clause 2. A method according to clause 1 wherein classifying pixels comprises comparing pixel values to a threshold to generate a comparison map from which the foreground pixel map is generated.

Clause 3. A method according to clause 2 wherein comparing pixel values to a threshold comprises comparing pixel values to a plurality of thresholds to generate a plurality of comparison maps from which a plurality of foreground pixel maps are generated and encoding the foreground pixel map comprises encoding each foreground pixel map as encoded data using a sparse matrix encoding technique.

Clause 4. A method according to clause 3 wherein the comparing comprises comparing pixel values to no more than 10 thresholds to generate no more than 10 comparison maps.

Clause 5. A method according to clause 1, 2, 3 or 4 further comprising reducing noise in the foreground pixel map(s).

Clause 6. A method according to clause 5 wherein reducing noise comprises applying an erosion kernel to the comparison map to generate an eroded map.

Clause 7. A method according to clause 6 wherein reducing noise further comprises applying a dilation kernel to the eroded map to generate the foreground pixel map.

Clause 8. A method according to any one of the preceding clauses wherein the sparse matrix encoding technique is selected from the group consisting of: dictionary of keys; list of lists; coordinate list; compressed sparse row; compressed sparse column; run-length encoding.

Clause 9. A method according to any one of the preceding clauses wherein the classifying and the encoding are performed in a first data processing device and further comprising transmitting the encoded data to a second data processing device remote from the first data processing device.

Clause 10. A method according to clause 9 wherein the first data processing device is contained in an assessment apparatus that scans the charged particle beam across the sample.

Clause 11. A method according to clause 10 wherein the second data processing device is remote from the assessment apparatus.

Clause 12. A method according to clause 9, 10 or 11 wherein the first data processing device comprises an FPGA, an ASIC or a GPU.

Clause 13. A method according to any one of the preceding clauses further comprising comparing the encoded data to a reference image to identify candidate defects, wherein the reference image is also encoded in the sparse matrix encoding technique.

Clause 14. A method according to clause 13 wherein the reference image is obtained from GDSII data.

Clause 15. A method according to clause 14 wherein the reference image is obtained by scanning a reference.

Clause 16. A method according to clause 13, 14 or 15 when dependent on any one of clauses 9 to 12 wherein the comparing is performed in the second data processing device.

Clause 17. A method according to any one of clauses 13 to 16, further comprising transmitting externally of the assessment apparatus a region of the image data containing a candidate defect.

Clause 18. A method according to any one of the preceding clauses wherein the image data is obtained using a multi-beam charged-particle assessment apparatus.

Clause 19. An assessment method comprising: directing a charged particle beam onto a sample; generating a digital detection signal of pixel values in response to signal particles from the sample; scanning the sample and the charged particle beam; and processing the digital detection signal using the method of any one of clauses 1 to 18.

Clause 20. A computer program for data processing, the computer program comprising instructions that, when executed by a data processing system, cause data processing system to perform a method according to any one of clauses 1 to 18.

Clause 21. A data encoding device for encoding image data obtained by scanning a charged particle beam across a sample, the device comprising: a classifier for classifying pixels of the image data into foreground pixels and background pixels to generate a foreground pixel map; and an encoder for encoding the foreground pixel map as encoded data using a sparse matrix encoding technique.

Clause 22. A data encoding device according to clause 21 wherein the classifier is configured to compare pixel values to a threshold to generate a comparison map from which the foreground pixel map is generated.

Clause 23. A data encoding device according to clause 22 wherein the classifier is configured to compare pixel values to a plurality of thresholds to generate a plurality of comparison maps from which a plurality of foreground pixel maps are generated and the encoder is configured to encode each foreground pixel map as encoded data using a sparse matrix encoding technique.

Clause 24. A data encoding device according to clause 23 wherein the classifier is configured to compare pixel values to no more than 10 thresholds to generate no more than 10 comparison maps.

Clause 25. A data encoding device according to clause 21, 22, 23 or 24 further comprising a noise filter configured to reduce noise in the foreground pixel map(s).

Clause 26. A data encoding device according to clause 25 wherein the noise filter comprises an erosion kernel configured to generate an eroded map from the comparison map.

Clause 27. A data encoding device according to clause 26 wherein the noise filter further comprises a dilation kernel configured to generate the foreground pixel map from the eroded map.

Clause 28. A data encoding device according to any one of clauses 21 to 27 wherein the encoder is configured to employ a sparse matrix encoding technique selected from the group consisting of: dictionary of keys; list of lists; coordinate list; compressed sparse row; compressed sparse column; run-length encoding.

Clause 29. A data encoding device according to any one of clauses 21 to 28 wherein encoder is further configured to transmit the encoded data to a data processing device remote from the data encoding device.

Clause 30. A data encoding device according to clause 29 that is contained in an assessment apparatus that scans the charged particle beam across the sample.

Clause 31. A data encoding device according to any one of clause 21 to 30 wherein at least a part of the classifier and/or the encoder is embodied in an FPGA, an ASIC or a GPU.

Clause 32. A data comparison device for detecting candidate defects in an image of a sample, the device comprising: an interface for receiving encoded sample data representing a foreground pixel map encoded using a sparse matrix encoding technique; and a comparator for comparing the encoded sample data to encoded reference data, the encoded reference data representing a foreground pixel map derived from a reference image and encoded using the sparse matrix encoding technique.

Clause 33. A data comparison device according to clause 32 wherein the reference image is obtained from GDSII data.

Clause 34. A data comparison device according to clause 32 wherein the reference image is obtained by scanning a reference.

Clause 35. A data comparison device according to any one of clauses 32 to 34, further comprising an output module configured to transmit externally of the data comparison device a region of the image data containing a candidate defect.

Clause 36. A data processing system comprising a data encoding device according to any one of clauses 21 to 31 and a data comparison device according to any one of clauses 32 to 35.

Clause 37. A charged particle assessment apparatus for scanning a charged particle beam across a sample; the apparatus comprising: a detector unit configured to output a digital detection signal of pixel values in response to signal particles incident from the sample; a scanning unit for relatively scanning the sample and the charged particle beam; and a data encoding device according to any one of clauses 21 to 31

Clause 38. A charged particle assessment apparatus according to clause 37 wherein the data encoding device is at least partially within a vacuum chamber.

Clause 39. A charged particle assessment system for assessing at least a portion of a sample, the charged particle assessment system comprising the charged particle assessment apparatus of clause 37 or 38 and a data comparison device according to any one of clauses 32 to 35.

Clause 40. A data structure comprising encoded sample data representing a foreground pixel map obtained by relatively scanning a sample and a charged particle beam, the foreground pixel map encoded using a sparse matrix encoding technique.

Clause 41. A method of processing detection data of a sample surface from a detector element of a detector array, the method comprising: scanning a charged particle beam across a sample region; detecting resulting signal particles using one or more detector elements of a charged particle detector array to obtain detection data; receiving pixels of detection data in a data stream from the detector element; in the datastream classifying pixels of the detection data into foreground pixels and background pixels to generate a foreground pixel dataset representative of the scanned sample region.

Clause 42. A method according to clause 41 wherein the detection data from a plurality of the detector elements is representable as an image of the sample surface.

Clause 43. A method according to clause 41 or 42 further comprising, in the datasteam, encoding, encoding the foreground pixel dataset as encoded data using an encoding operator.

Clause 44. A method according to clause 41, 42 or 43 wherein the classifying and/or the encoding are performed in the detector and/or a first data processing device and further comprising transmitting the encoded data to a second data processing device remote from the detector or the first data processing device.

While the present invention has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the following claims.

## Claims

1. A data processing method for image data obtained by scanning a charged particle beam across a sample; the method comprising:
classifying pixels of the image data into foreground pixels and background pixels to generate a foreground pixel map; and
encoding the foreground pixel map as encoded data using a sparse matrix encoding technique.

2. A method according to claim 1 wherein classifying pixels comprises comparing pixel values to a threshold to generate a comparison map from which the foreground pixel map is generated.

3. A method according to claim 2 wherein comparing pixel values to a threshold comprises comparing pixel values to a plurality of thresholds to generate a plurality of comparison maps from which a plurality of foreground pixel maps are generated and encoding the foreground pixel map comprises encoding each foreground pixel map as encoded data using a sparse matrix encoding technique.

4. A method according to claim 3 wherein the comparing comprises comparing pixel values to no more than 10 thresholds to generate no more than 10 comparison maps.

5. A method according to claim 1, 2, 3 or 4 further comprising reducing noise in the foreground pixel map(s).

6. A method according to claim 5 wherein reducing noise comprises applying an erosion kernel to the comparison map to generate an eroded map.

7. A method according to any of the preceding claims wherein the classifying and the encoding are performed in a first data processing device and further comprising transmitting the encoded data to a second data processing device remote from the first data processing device.

8. A method according to claim 7 wherein the first data processing device is contained in an assessment apparatus that scans the charged particle beam across the sample.

9. A method according to claim 8 wherein the second data processing device is remote from the assessment apparatus.

10. A method according to any of the preceding claims further comprising comparing the encoded data to a reference image to identify candidate defects, wherein the reference image is also encoded in the sparse matrix encoding technique.

11. A method according to claim 10 wherein the reference image is obtained from GDSII data or the reference image is obtained by scanning a reference.

12. A method according to claim 10 to 11, further comprising transmitting externally of the assessment apparatus a region of the image data containing a candidate defect.

13. A method according to any of the preceding claims wherein the image data is obtained using a multi-beam charged-particle assessment apparatus.

14. A computer program for data processing, the computer program comprising instructions that, when executed by a data processing system, cause data processing system to perform a method according to any one of claims 1 to 13.

15. A data encoding device for encoding image data obtained by scanning a charged particle beam across a sample, the device comprising:
a classifier for classifying pixels of the image data into foreground pixels and background pixels to generate a foreground pixel map; and
an encoder for encoding the foreground pixel map as encoded data using a sparse matrix encoding technique.
